# EUROPEAN PATENT SPECIFICATION

(11) **EP 4 244 637 B1**
(45) Date of publication and mention of the grant of the patent: **10.07.2024**
(21) Application number: 22702383.5
(22) Date of filing: 17.01.2022
(51) Int. Cl.: G01R 31/12, H02H 1/00

(54) **ARC FAULT DETECTION BY ACCUMULATION OF MACHINE LEARNING CLASSIFICATIONS IN A CIRCUIT BREAKER**
LICHTBOGENFEHLERERKENNUNG DURCH ANHÄUFUNG VON MASCHINENLERNKLASSIFIKATIONEN IN EINEM SCHUTZSCHALTER
DÉTECTION D'ARC DE COURT-CIRCUIT PAR ACCUMULATION DE CLASSIFICATIONS D'APPRENTISSAGE MACHINE DANS UN DISJONCTEUR

(30) Priority: 01.02.2021 US 202117163997
(43) Date of publication of application: 20.09.2023
(73) Proprietor: Siemens Industry, Inc., Alpharetta, Georgia 30005-4437 (US)
(72) Inventor: LEIDY, Matthew, Norcross, Georgia 30092 (US); WILLIAMS, Westin, Marietta, Georgia 30066 (US)
(74) Representative: Isarpatent
(86) International application number: PCT/US2022/012654
(87) International publication number: WO 2022/164663

(56) References cited:
- US-A1- 2002 118 022
- US-A1- 2008 030 199
- KEYHANI R ET AL: "A high impedance fault detector using a neural network and subband decomposition", SIGNAL PROCESSING AND ITS APPICATIONS, SIXTH INTERNATIONAL, SYMPOSIUM ON. 2001 AUG. 16-16, 2001, PISCATAWAY, NJ, USA,IEEE, vol. 2, 16 August 2001 (2001-08-16), pages 458 - 461, XP010557086, ISBN: 978-0-7803-6703-6
- VU HIEN DUC ET AL: "Multi criteria series arc fault detection based on supervised feature selection", INTERNATIONAL JOURNAL OF ELECTRICAL POWER & ENERGY SYSTEMS, vol. 113, 18 May 2019 (2019-05-18), pages 23 - 34, XP085724375, ISSN: 0142-0615, DOI: 10.1016/J.IJEPES.2019.05.012

## Description

### BACKGROUND

### 1. Field

Aspects of the present invention generally relate to arc fault detection by accumulation of machine learning classifications in a circuit breaker.

### 2. Description of the Related Art

Circuit breakers are essential for electrical safeties. They feed current to loads that are connected to them and interrupt the circuit once a circuit fault such as an overload, a short circuit, a ground fault and an arc fault is detected. We need the capabilities of an arc fault circuit interrupter (AFCI) in detecting and tripping on arc faults without causing unwanted tripping on various residential products (i.e. lighting, microwaves, vacuum cleaners, power tools, etc.). An arc fault circuit interrupter (AFCI) is an advanced circuit breaker that, as a way to reduce electrical fire threats, breaks the circuit when it detects a dangerous electric arc in the circuit that it protects.

AFCIs rely on internal electronics to analyze various analog signals (current and voltage) that pass through the circuit breaker to determine if an arc fault exists downstream of it. Prior art investigations tend to ignore utilizing the inferences from a machine learning classifier (neural network or other) to accumulate positive inferences (and decrement negative inferences) into a final decision to trip the circuit breaker in a specific amount of time to meet the safety limits detailed in various industry standards (e.g., UL1699 or other equivalents). Prior art AFCI's are known from US2002/118022, US2008/030199, nad from the IEEE papers KEYHANI: "A high impedance fault detector using a neural network and subband decomposition", SIGNAL PROCESSING AND ITS APPICATIONS, SIXTH INTERNATIONAL, SYMPOSIUM 2001, pages 458-461, XP010557086; and VU: "Multi criteria series arc fault detection based on supervised feature selection", INTERNATIONAL JOURNAL OF ELECTRICAL POWER & ENERGY SYSTEMS, vol. 113, 18 May 2019, pages 23-34, XP085724375, each describing AFCI's involving sampling and preprocessing analog signals, neural network classifiers, and counters/accumulators, but none providing a temporal data set that is fed to a machine learning classifier that indicates a probability that the set comprises an arcing event, followed by incrementing or decrementing an accumulator based on the probability and in proportion to the current flowing in the breaker; and signalling the breaker to trip if the accumulator value exceeds a threshold.

Therefore, there is a need for a better arc fault detection in a circuit breaker.

### SUMMARY

Briefly described, aspects of the present invention relate to thermal management in a circuit breaker. The objective of the described invention is to focus on the types of signals and measurements to be made and analyzed, including investigations into the use of various machine learning mechanisms. A final step of utilizing the inferences from the machine learning classifier (neural network or other) is designed to accumulate positive inferences (and decrement negative inferences) into making a final decision to trip the breaker in a specific amount of time to meet the safety limits detailed in various industry standards (e.g., UL1699 or other equivalents).

In accordance with one illustrative embodiment of the present invention, a circuit breaker comprises a microcontroller including a processor and a memory. The circuit breaker further comprises computer-readable software code stored in the memory which, when executed by the processor, causes the microcontroller to: sample analog signals representing one or more of the following: a Received Signal Strength Indicator (RSSI) signal, a voltage signal, and a current signal, perform multiple pre-processing steps on the analog signals to derive a data set of measurements and features over a period of time, and input the data set into a machine learning classifier that resides in the microcontroller such that an output of the machine learning classifier is a value between 0 and 1 which represents a percent chance that the data set is from an electrical arc. Based on the value of the percent chance an accumulator value is either incremented or decremented in proportion to an amount of the current passing through the circuit breaker and if the accumulator value passes an upper threshold level, the microcontroller sends a signal output to a trip circuit which then opens the circuit breaker.

In accordance with one illustrative embodiment of the present invention, a method of arc fault detection by accumulation of machine learning classifications is provided. The method comprises providing a microcontroller including a processor and a memory. The method further comprises providing computer-readable software code stored in the memory which, when executed by the processor, causes the microcontroller to: sample analog signals representing one or more of the following: a Received Signal Strength Indicator (RSSI) signal, a voltage signal, and a current signal, perform multiple pre-processing steps on the analog signals to derive a data set of measurements and features over a period of time, and input the data set into a machine learning classifier that resides in the microcontroller such that an output of the machine learning classifier is a value between 0 and 1 which represents a percent chance that the data set is from an electrical arc. Based on the value of the percent chance an accumulator value is either incremented or decremented in proportion to an amount of the current passing through the circuit breaker and if the accumulator value passes an upper threshold level, the microcontroller sends a signal output to a trip circuit which then opens the circuit breaker.

### BRIEF DESCRIPTION OF THE DRAWINGS

FIG. 1 illustrates a circuit breaker in accordance with an exemplary embodiment of the present invention.
FIG. 2 illustrates an exploded view of the circuit breaker of FIG. 1 in accordance with an exemplary embodiment of the present invention.
FIG. 3 illustrates a block diagram of a circuit breaker in accordance with an exemplary embodiment of the present invention.
FIG. 4 illustrates a circuit block diagram of a circuit breaker in accordance with an exemplary embodiment of the present invention.
FIG. 5 illustrates description of a neural network in accordance with an exemplary embodiment of the present invention.
FIG. 6 illustrates a neural network model, neural network training, a hidden layer in accordance with an exemplary embodiment of the present invention.
FIG. 7 illustrates a machine learning approach for arc detection in accordance with an exemplary embodiment of the present invention.
FIG. 8 illustrates a machine learning classifier in accordance with an exemplary embodiment of the present invention.
FIG. 9 illustrates neural network features in accordance with an exemplary embodiment of the present invention.
FIG. 10 illustrates neural network summary in accordance with an exemplary embodiment of the present invention.
FIG. 11 illustrates a flow diagram for the software code running in the microcontroller in accordance with an exemplary embodiment of the present invention.
FIG. 12 illustrates an example of accumulator incrementing as a neural network (NN) algorithm detects electrical arc events using current and RSSI signals at each half-cycle in accordance with an exemplary embodiment of the present invention.
FIG. 13 illustrates a schematic view of a flow chart of a method of arc fault detection by accumulation of machine learning classifications in a circuit breaker in accordance with an exemplary embodiment of the present invention.

### DETAILED DESCRIPTION

To facilitate an understanding of embodiments, principles, and features of the present invention, they are explained hereinafter with reference to implementation in illustrative embodiments. In particular, they are described in the context of utilization of a machine learning classifier with a meaningful accumulation of inferences over time to create a fully working arc detection and interruption algorithm in an AFCI. A circuit breaker with software code provides classifications per half-cycle through accumulation of an inference output from a machine learning classifier for providing a final decision to trip the circuit breaker in a specific amount of time to meet the safety limits detailed in various industry standards. Embodiments of the present invention, however, are not limited to use in the described devices or methods.

The components and materials described hereinafter as making up the various embodiments are intended to be illustrative and not restrictive. Many suitable components and materials that would perform the same or a similar function as the materials described herein are intended to be embraced within the scope of embodiments of the present invention.

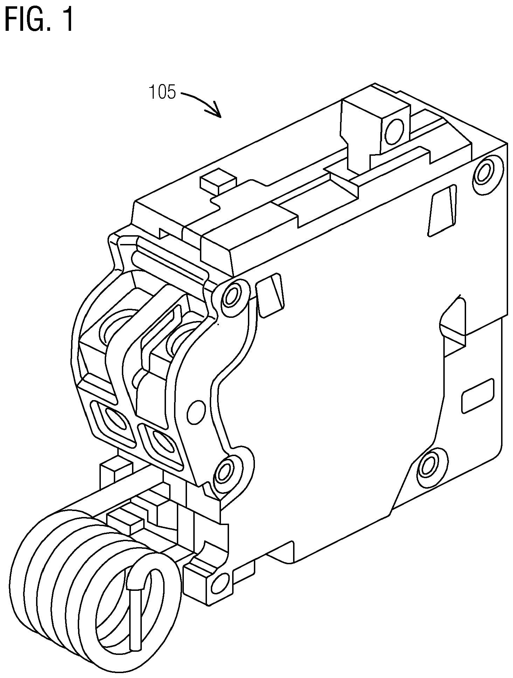

These and other embodiments of the circuit breaker according to the present disclosure are described below with reference to FIGs. 1-13 herein. Like reference numerals used in the drawings identify similar or identical elements throughout the several views. The drawings are not necessarily drawn to scale.

Consistent with one embodiment of the present invention, FIG. 1 represents a circuit breaker 105 in accordance with an exemplary embodiment of the present invention. The circuit breaker 105 is an arc fault circuit interrupter (AFCI) with the capabilities of detecting and tripping on arc faults without causing unwanted tripping on various residential products (i.e. lighting, microwaves, vacuum cleaners, power tools, etc.). An arc fault circuit interrupter (AFCI) is an advanced circuit breaker that, as a way to reduce electrical fire threats, breaks the circuit when it detects a dangerous electric arc in the circuit that it protects. AFCIs rely on internal electronics to analyze various analog signals (current and voltage) that pass through the circuit breaker 105 to determine if an arc fault exists downstream of it.

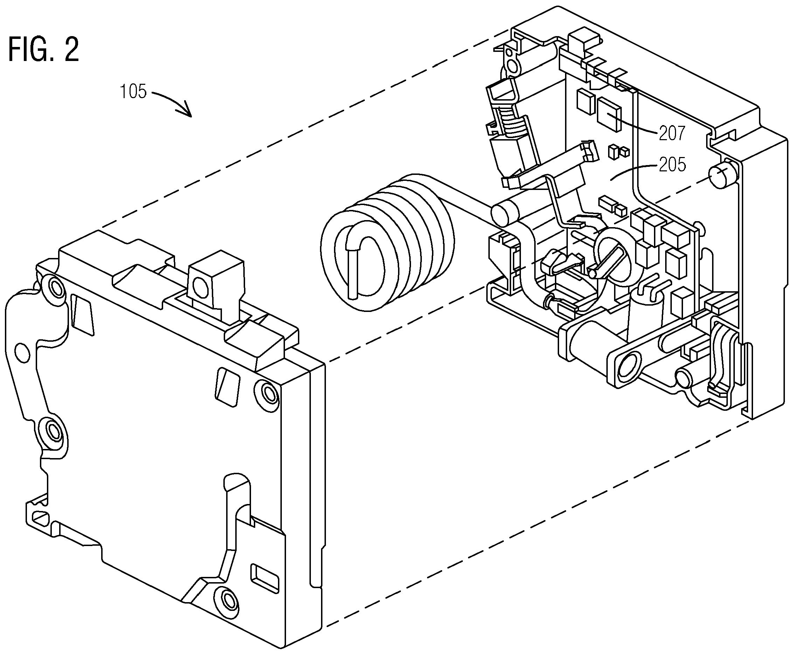

Referring to FIG. 2, it illustrates an exploded view of the circuit breaker 105 of FIG. 1 in accordance with an exemplary embodiment of the present invention. This is an isometric view of an AFCI. The right-side cutaway shows a printed circuit board assembly (PCBA) 205, which contains a microcontroller 207 and accompanying circuitry. The microcontroller 207 includes a logic for detecting and tripping the circuit breaker 105 for overcurrent, differential, and arc faults.

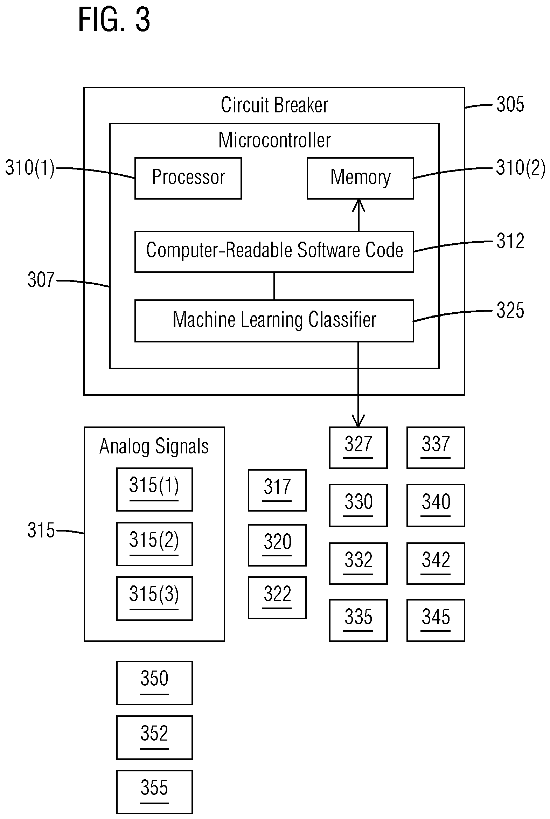

Turning now to FIG. 3, it illustrates a block diagram of a circuit breaker 305 in accordance with an exemplary embodiment of the present invention. The circuit breaker 305 comprises a microcontroller 307 including a processor 310(1) and a memory 310(2). The circuit breaker 305 further comprises computer-readable software code 312 stored in the memory 310(2) which, when executed by the processor 310(1), causes the microcontroller 307 to sample analog signals 315 representing one or more of the following: a Received Signal Strength Indicator (RSSI) signal 315(1), a voltage signal 315(2), and a current signal 315(3). Execution of the computer-readable software code 312 further causes the microcontroller 307 to perform multiple pre-processing steps 317 on the analog signals 315 to derive a data set 320 of measurements and features over a period of time, e.g., for every half-cycle 322 of current passing through the circuit breaker 305. Execution of the computer-readable software code 312 further causes the microcontroller 307 to input the data set 320 into a machine learning classifier 325 that resides in the microcontroller 307 such that an output 327 of the machine learning classifier 325 is a value between 0 and 1 which represents a percent chance 330 that the data set 320 is from an electrical arc 332. Based on the value of the percent chance 330 an accumulator value 335 is either incremented or decremented in proportion to an amount of the current 337 passing through the circuit breaker 305 and if the accumulator value 335 passes an upper threshold level 340, the microcontroller 307 sends a signal output 342 to a trip circuit 345 which then opens the circuit breaker 305.

The machine learning classifier 325 may be a trained neural network. The analog signals 315 data is analyzed and classified from specific pre-processing features at each half-cycle by the machine learning classifier 325.

The Received Signal Strength Indicator (RSSI) signal 315(1) and the current signal 315(3) come from an analog front-end ASIC circuitry 350. The analog front-end ASIC circuitry 350 acts as an interface between a radio frequency (RF) coupler, shunt resistance sensors and the microcontroller 307. The microcontroller 307 includes a logic 352 for detecting and tripping the circuit breaker 305 for overcurrent, differential, and arc faults.

In operation, the computer-readable software code 312 is to digitally convert the Received Signal Strength Indicator (RSSI) signal 315(1), the voltage signal 315(2), and the current signal 315(3). Then extract half-cycle features 355 from the Received Signal Strength Indicator (RSSI) signal 315(1), the voltage signal 315(2), and the current signal 315(3). Next, run half-cycle features 355 set through the machine learning classifier 325 and analyze an output of the machine learning classifier 325 to determine if half-cycle was an arc or not. If there is an arc inference, the computer-readable software code 312 is to increment the accumulator value 335 proportional to an amount of the current. The computer-readable software code 312 is to check whether the accumulator value 335 exceeds a max accumulator threshold and if so trip the circuit breaker 305. If there is no arc inference, the computer-readable software code 312 is to decrement the accumulator value 335 proportional to an amount of the current.

In the above case, an analog signal representing the RSSI level present on the residential wiring downstream of an AFCI is measured and analyzed in real-time to produce a set of features at the end of each half-cycle of the power line frequency (i.e. every 8.33ms for the 60Hz frequency in the U.S.). These features are then fed into the machine learning classifier 325 (in our case a neural network, but other classifier types could also be used) that has been previously trained to recognize arc faults. The output of the classifier 325 is a number between 0 and 1 representing the percent confidence that the last half-cycle was an electrical arc. Presently we have a flat threshold that if this output value exceeds the computer-readable software code 312 will increment a separate stored value (called an accumulator) in proportion to the amount of current present during this half-cycle event (e.g., a peak value of the current during this half-cycle, but other common measurements such as RMS or average could also be used). If the classifier 325 value is less than a threshold, the computer-readable software code 312 in turn decrements the accumulator by the same amount, in proportion to the amount of current present in that half-cycle. If the accumulator passes a maximum threshold an arc fault will have been deemed to be present, and the AFCI will trip to open the circuit. This incrementing and decrementing of the accumulator works to average out multiple inferences over time while weighting for the amount of current present, to ensure that the AFCI will trip within safe limits while also giving a maximum amount of time for discrimination of residential loads to minimize unwanted tripping.

While one embodiment has a hard threshold for incrementing/decrementing, the inference itself could also be used in further weighting schemes, such as one where inferences at the min/max of 0 or 1 would result in full changes to the accumulator (still also weighted by the amount of current), with the shift being scaled down to 0 the closer the inference is to 0.5 (where the classifier 325 isn't sure if it is an arc or not).

One main advantage is that this approach gives us a complete method for utilizing the power of machine learning in AFCIs. Whereas in the past arc detection analysis algorithms had to be created and improved by various individuals, sometimes resulting in delays of days or weeks to fix performance issues found during testing or in the field, now it will become a simpler matter of capturing the data from the nonconformity and adding it to our machine learning training set, shortening the time it takes to update the AFCI software with performance improvements. The specific utilization of the machine learning classifier 325 with a meaningful accumulation of inferences over time to create a fully working arc detection and interruption algorithm in an AFCI is provided.

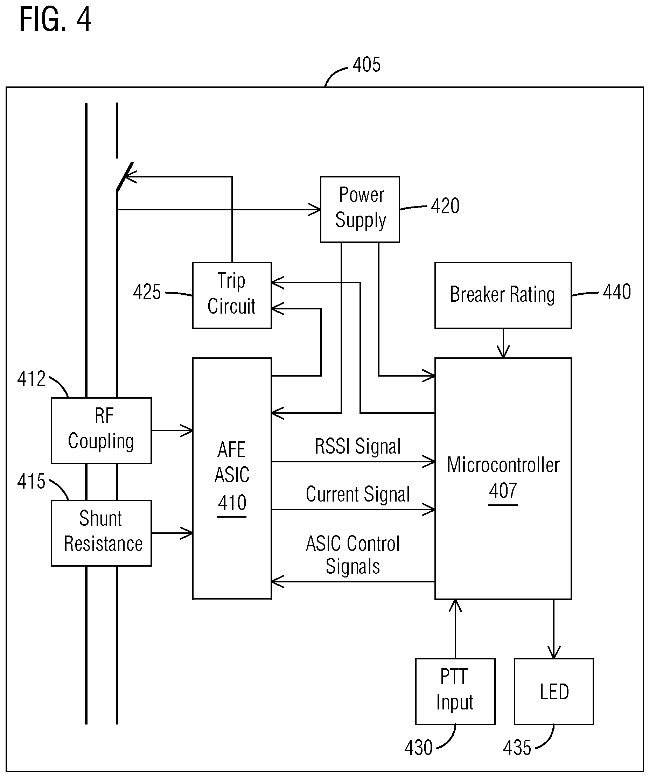

FIG. 4 illustrates a circuit block diagram of a circuit breaker such as an AFCI 405 in accordance with an exemplary embodiment of the present invention. The hardware architecture of electronics in the AFCI 405 consists of following component blocks. A microcontroller 407 contains all of logic for detecting and tripping the AFCI 405 for overcurrent, differential, and arc faults. An analog front end (AFE) ASIC 410 acts as an interface between a RF coupler and shunt resistance sensors and the microcontroller 407. It contains a voltage amplifier (with 4 gain settings) for the shunt and a received signal strength indicator (RSSI) circuit for the RF coupler. A RF coupling 412 is performed using a capacitive coupling circuit connected to a 120V line voltage. A shunt resistance 415 is on a neutral line and is used to measure the current passing through the AFCI 405. It is connected to a voltage amplifier in the ASIC 410. A power supply 420 being an AC/DC switching supply converts the 120V line voltage to 5V and 3.3V for the ASIC 410, the microcontroller 407, and a differential circuit. A trip circuit 425 consists of a SCR and a coil and is used to trip the AFCI 405. A push-to-test (PTT) input 430 is provided as a pushbutton on the AFCI 405 which allows the user to initiate a self-test of the breaker electronics. A LED 435 is used to indicate a last trip type to the user upon breaker power-up. The LED 435 will also indicate if the AFCI 405 failed to trip for a fault. A breaker rating 440 is an input to the microcontroller 407 which identifies the rating of the AFCI 405 (15A or 20A).

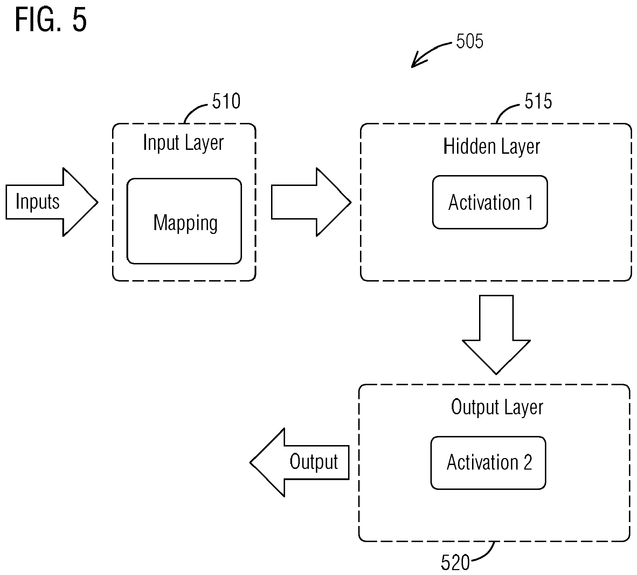

As seen in FIG. 5, it illustrates description of a neural network (NN) 505 in accordance with an exemplary embodiment of the present invention. The NN 505 comprises an input layer 5 10, a hidden layer 515 and an output layer 520.

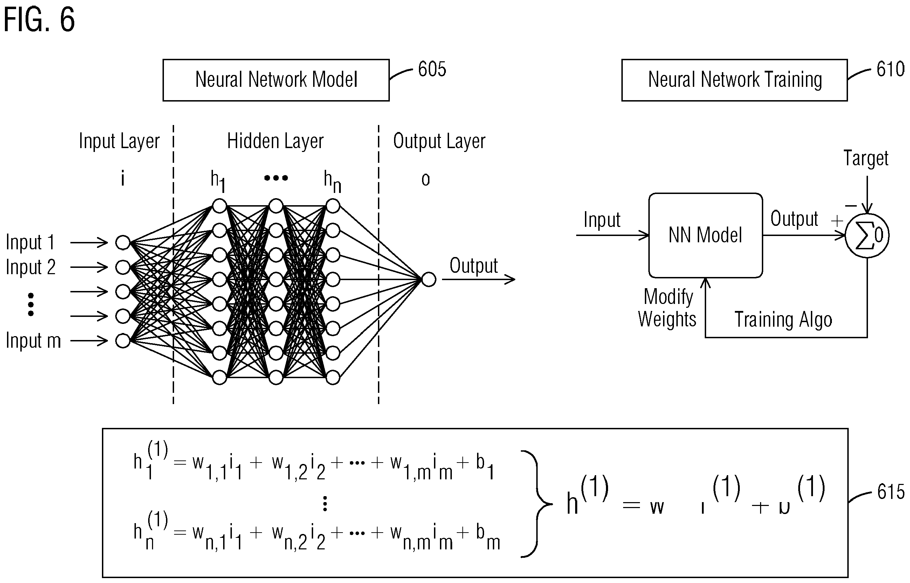

As shown in FIG. 6, it illustrates a neural network model 605, neural network training 610, a hidden layer 615 in accordance with an exemplary embodiment of the present invention. The neural network model 605 is represented by its architecture that shows how to transform two or more inputs into an output. The transformation is given in the form of a learning algorithm. The neural network training 610, i.e., training a Neural Network (NN) means finding the appropriate weights of the Neural Connections using a feedback loop. A NN training involves feedforward of data signals to generate the output and then the backpropagation of errors for gradient descent optimization.

Training data includes split - 80% training, 0% validation, 20% testing, samples of arcing, and samples of nuisance and randomized distribution of samples in split. The training method may update the weight and bias values according to optimization and minimizes a combination of squared errors and weights to determine the correct combination so as to produce a network which generalizes well. Training method parameters left set to 'default' (Note: Does not need validation data set). The performance function is Mean-squared Error. This determines the overall performance of the network by comparing the target vs. desired output.

The hidden layer 615 is located between the input and output of the algorithm, in which the function applies weights to the inputs and directs them through an activation function as the output. In short, the hidden layers perform nonlinear transformations of the inputs entered into the neural network.

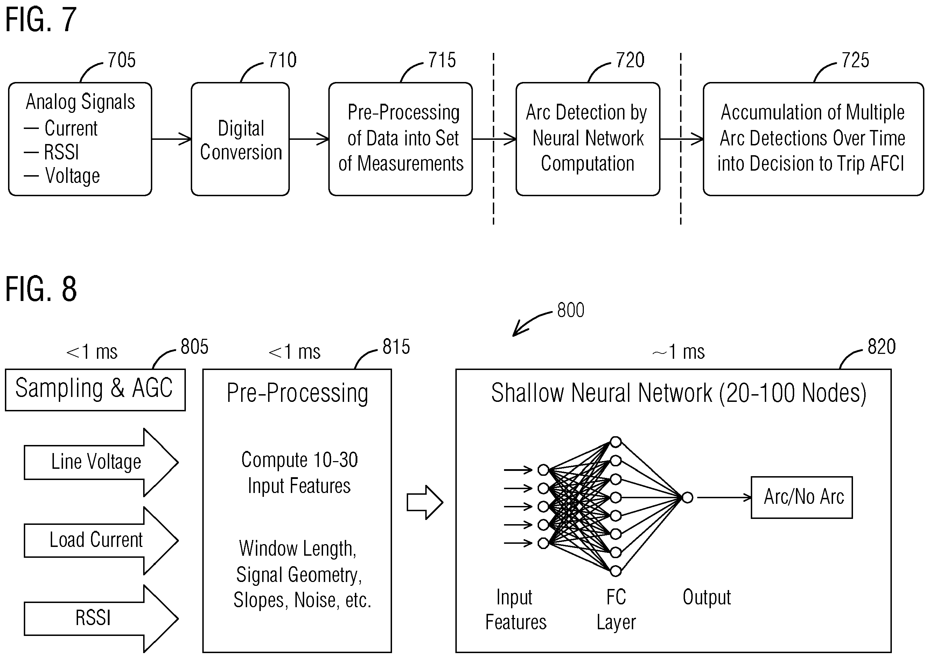

In FIG. 7, it illustrates a machine learning approach 700 for arc detection in accordance with an exemplary embodiment of the present invention. At a step 705, analog signals including current, RSSI, and voltage are received. At a step 710, digital conversion of the analog signals is performed. Pre-processing of data is done into set of measurements at a step 715. Arc detection is done by Neural Network computation instead of data comparison to multiple thresholds at a step 720. At a step 725, accumulation of multiple arc detections over time goes into a decision to trip an AFCI.

With regard to FIG. 8, it illustrates a machine learning classifier 800 in accordance with an exemplary embodiment of the present invention. This is a high-level diagram describing the process mentioned above where signal data is analyzed and classified from specific pre-processing features at each half-cycle. The machine learning classifier 800 comprises three stages. The first stage is sampling and automatic gain control (AGC) 805. It samples a line voltage 810(1), a load current 810(2), and a RSSI 810(3). Next stage is pre-processing 815 in which signal features are computed such as window length, signal geometry, slopes, noise etc. The final stage is a shallow neural network 820 with a predefined number of nodes. Input features are fed into a FC layer and an output is generated in terms of an arc or no arc.

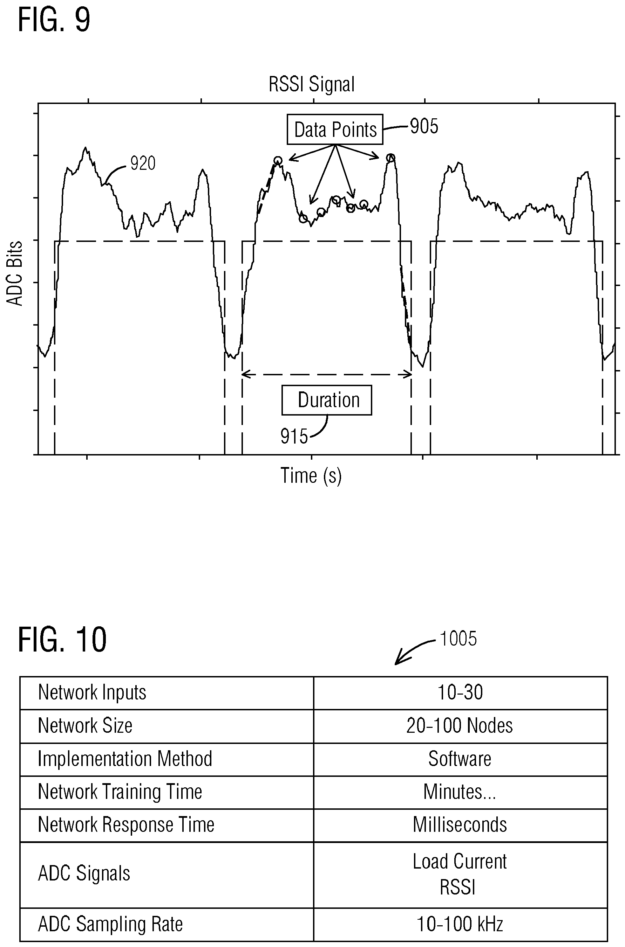

With respect to FIG. 9, it illustrates neural network features in accordance with an exemplary embodiment of the present invention. The features for a neural network include specific data points 905 during an event, slope of a waveform 920 at the start and end and a half-cycle duration 915.

FIG. 10 illustrates neural network summary 1005 in accordance with an exemplary embodiment of the present invention. The neural network summary 1005 includes 10-30 network inputs, a network size of 20-100 nodes, a network training time of minutes, a network response time of 3 milliseconds, ADC signals of load current, RSSI and an ADC sampling rate of 10-100 kHz.

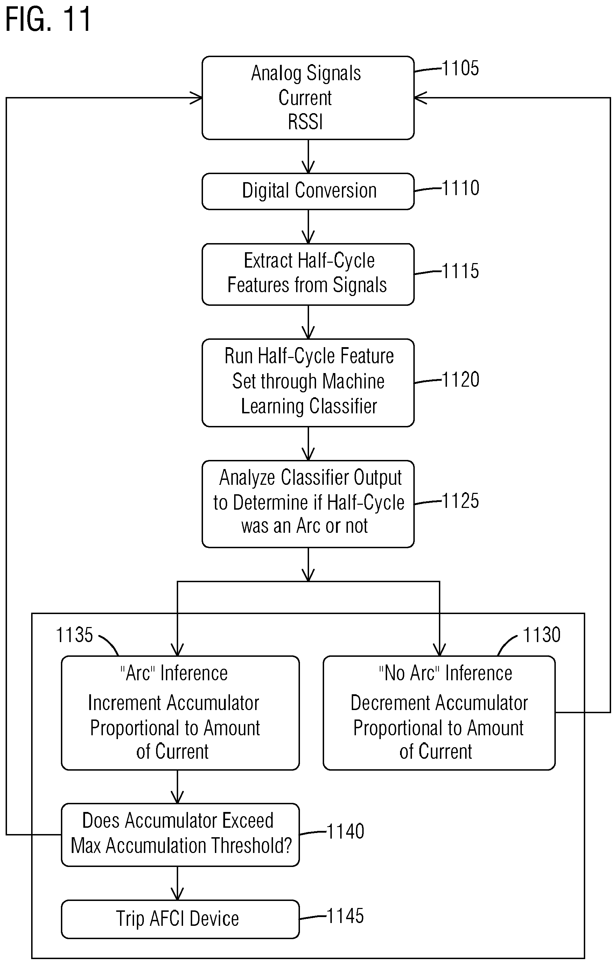

FIG. 11 illustrates a flow diagram for the software code 312 running in the microcontroller 207, 307, 407 in accordance with an exemplary embodiment of the present invention. The software code 312 provides classifications per half-cycle through accumulation of an inference output from a machine learning classifier.

At a step 1105, analog signals including current and RSSI are received. At a step 1110, digital conversion of the analog signals is performed by the software code 312. Next, at a step 1115, the software code 312 extracts half-cycle features from the analog signals. Then in a step 1120 the software code 312 runs a half-cycle feature set through a machine learning classifier. Thereafter, at a step 1125 the software code 312 analyzes an output of the machine learning classifier to determine if the half-cycle was an arc or not. At a step 1130, if a no arc inference is derived, an accumulator value is decremented proportional to an amount of current. At a step 1135, if an arc inference is derived, an accumulator value is incremented proportional to an amount of current. At a step 1140, a check is made to determine if the accumulator value exceeded a max accumulation threshold. If the determination in the step 1140 is "yes" then at a step 1145 an AFCI device is tripped.

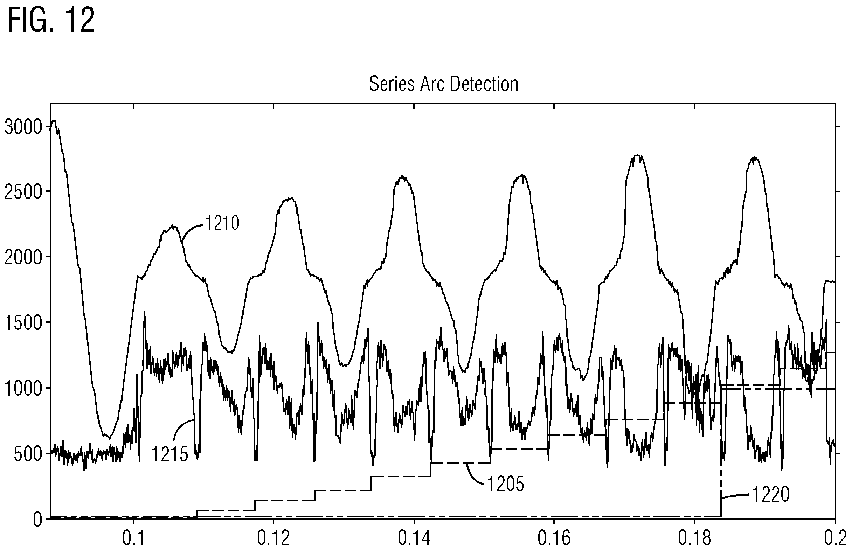

FIG. 12 illustrates an example of accumulator incrementing as a neural network (NN) algorithm detects electrical arc events using current and RSSI signals at each half-cycle in accordance with an exemplary embodiment of the present invention. This is an example of an accumulator incrementing 1205 as a NN algorithm detects electrical arc events using current 1210 and RSSI 1215 signals at each half-cycle. Once the accumulator reaches a defined threshold value it sends a trip signal 1220 to open a circuit breaker. The threshold value shown here is normalized to 1000.

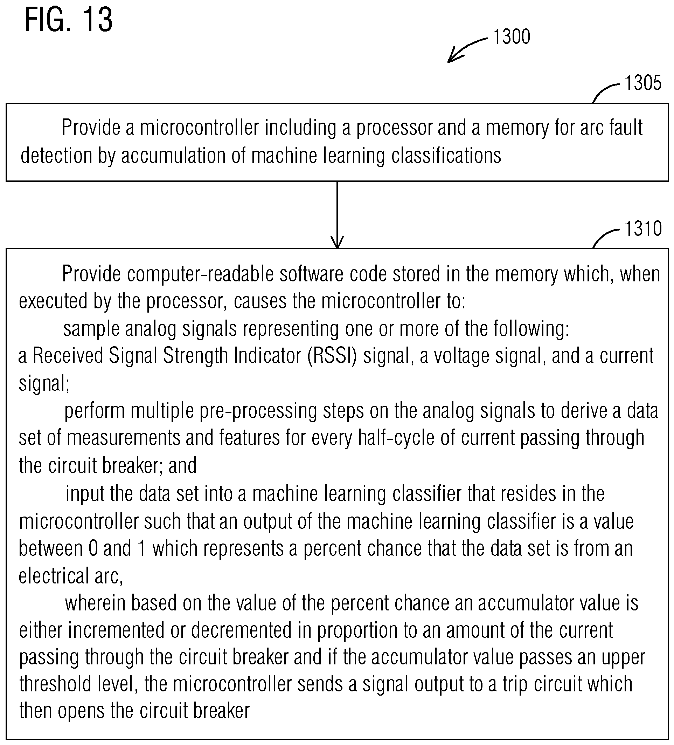

FIG. 13 illustrates a schematic view of a flow chart of a method 1300 of arc fault detection by accumulation of machine learning classifications in a circuit breaker in accordance with an exemplary embodiment of the present invention. Reference is made to the elements and features described in FIGs. 1-12. It should be appreciated that some steps are not required to be performed in any particular order, and that some steps are optional.

The method 1300 comprises a step 1305 of providing a microcontroller including a processor and a memory. The method 1300 further comprises a step 1310 of providing computer-readable software code stored in the memory which, when executed by the processor, causes the microcontroller to: sample analog signals representing one or more of the following: a Received Signal Strength Indicator (RSSI) signal, a voltage signal, and a current signal, perform multiple pre-processing steps on the analog signals to derive a data set of measurements and features for every half-cycle of current passing through the circuit breaker, and input the data set into a machine learning classifier that resides in the microcontroller such that an output of the machine learning classifier is a value between 0 and 1 which represents a percent chance that the data set is from an electrical arc. Based on the value of the percent chance an accumulator value is either incremented or decremented in proportion to an amount of the current passing through the circuit breaker and if the accumulator value passes an upper threshold level, the microcontroller sends a signal output to a trip circuit which then opens the circuit breaker.

While a multi-layer neural network as a machine learning classifier is described here a range of one or more other types of machine learning classifiers or other forms of machine learning classifiers are also contemplated by the present invention. For example, other types of machine learning classifiers may be implemented based on one or more features presented above without deviating from the present invention.

The techniques described herein can be particularly useful for arc detection in an AFCI circuit breaker. While particular embodiments are described in terms of specific configuration of an AFCI, the techniques described herein are not limited to such a limited configuration but can also be used with other configurations and types of circuit breakers.

While embodiments of the present invention have been disclosed in exemplary forms, it will be apparent to those skilled in the art that many modifications, additions, and deletions can be made therein without departing from the scope of the invention and its equivalents, as set forth in the following claims.

Embodiments and the various features and advantageous details thereof are explained more fully with reference to the non-limiting embodiments that are illustrated in the accompanying drawings and detailed in the following description. Descriptions of well-known starting materials, processing techniques, components and equipment are omitted so as not to unnecessarily obscure embodiments in detail. It should be understood, however, that the detailed description and the specific examples, while indicating preferred embodiments, are given by way of illustration only and not by way of limitation. Various substitutions, modifications, additions and/or rearrangements within the scope of the underlying inventive concept will become apparent to those skilled in the art from this disclosure.

As used herein, the terms "comprises," "comprising," "includes," "including," "has," "having" or any other variation thereof, are intended to cover a non-exclusive inclusion. For example, a process, article, or apparatus that comprises a list of elements is not necessarily limited to only those elements but may include other elements not expressly listed or inherent to such process, article, or apparatus.

Additionally, any examples or illustrations given herein are not to be regarded in any way as restrictions on, limits to, or express definitions of, any term or terms with which they are utilized. Instead, these examples or illustrations are to be regarded as being described with respect to one particular embodiment and as illustrative only. Those of ordinary skill in the art will appreciate that any term or terms with which these examples or illustrations are utilized will encompass other embodiments which may or may not be given therewith or elsewhere in the specification and all such embodiments are intended to be included within the scope of that term or terms.

In the foregoing specification, the invention has been described with reference to specific embodiments. However, one of ordinary skill in the art appreciates that various modifications and changes can be made without departing from the scope of the invention. Accordingly, the specification and figures are to be regarded in an illustrative rather than a restrictive sense, and all such modifications are intended to be included within the scope of invention.

Although the invention has been described with respect to specific embodiments thereof, these embodiments are merely illustrative, and not restrictive of the invention. The description herein of illustrated embodiments of the invention is not intended to be exhaustive or to limit the invention to the precise forms disclosed herein (and in particular, the inclusion of any particular embodiment, feature or function is not intended to limit the scope of the invention to such embodiment, feature or function). Rather, the description is intended to describe illustrative embodiments, features and functions in order to provide a person of ordinary skill in the art context to understand the invention without limiting the invention to any particularly described embodiment, feature or function. While specific embodiments of, and examples for, the invention are described herein for illustrative purposes only, various equivalent modifications are possible within the scope of the invention, as those skilled in the relevant art will recognize and appreciate. As indicated, these modifications may be made to the invention in light of the foregoing description of illustrated embodiments of the invention and are to be included within the scope of the invention. Thus, while the invention has been described herein with reference to particular embodiments thereof, a latitude of modification, various changes and substitutions are intended in the foregoing disclosures, and it will be appreciated that in some instances some features of embodiments of the invention will be employed without a corresponding use of other features without departing from the scope of the invention as set forth. Therefore, many modifications may be made to adapt a particular situation or material to the essential scope of the invention.

Respective appearances of the phrases "in one embodiment," "in an embodiment," or "in a specific embodiment" or similar terminology in various places throughout this specification are not necessarily referring to the same embodiment. Furthermore, the particular features, structures, or characteristics of any particular embodiment may be combined in any suitable manner with one or more other embodiments. It is to be understood that other variations and modifications of the embodiments described and illustrated herein are possible in light of the teachings herein and are to be considered as part of the scope of the invention.

In the description herein, numerous specific details are provided, such as examples of components and/or methods, to provide a thorough understanding of embodiments of the invention. One skilled in the relevant art will recognize, however, that an embodiment may be able to be practiced without one or more of the specific details, or with other apparatus, systems, assemblies, methods, components, materials, parts, and/or the like. In other instances, well-known structures, components, systems, materials, or operations are not specifically shown or described in detail to avoid obscuring aspects of embodiments of the invention. While the invention may be illustrated by using a particular embodiment, this is not and does not limit the invention to any particular embodiment and a person of ordinary skill in the art will recognize that additional embodiments are readily understandable and are a part of this invention.

It will also be appreciated that one or more of the elements depicted in the drawings/figures can also be implemented in a more separated or integrated manner, or even removed or rendered as inoperable in certain cases, as is useful in accordance with a particular application.

Benefits, other advantages, and solutions to problems have been described above with regard to specific embodiments. However, the benefits, advantages, solutions to problems, and any component(s) that may cause any benefit, advantage, or solution to occur or become more pronounced are not to be construed as a critical, required, or essential feature or component.

## Claims

1. A circuit breaker (305; 405), comprising:
a microcontroller (307; 407) including a processor (310(1)) and a memory (310(2)),
computer-readable software code (312) stored in the memory which, when executed by the processor, causes the microcontroller to:
sample analog signals (705) representing one or more of the following: a Received Signal Strength Indicator, RSSI, signal, a voltage signal, and a current signal;
perform multiple pre-processing steps (715) on the analog signals to derive a data set of measurements and features over a period of time; and
input the data set into a machine learning classifier (325; 720) that resides in the microcontroller such that an output of the machine learning classifier is a value between 0 and 1 which represents a percent chance that the data set is from an electrical arc,
wherein (725) based on the value of the percent chance an accumulator value is either incremented or decremented in proportion to an amount of the current passing through the circuit breaker and if the accumulator value passes an upper threshold level, the microcontroller sends a signal output to a trip circuit (425) which then opens the circuit breaker.

2. The circuit breaker of claim 1, wherein the period of time is a duration of a half-cycle of the current passing through the circuit breaker and wherein the Received Signal Strength Indicator, RSSI, signal and the current signal come from an analog front-end ASIC circuitry.

3. The circuit breaker of claim 2, wherein the analog front-end ASIC circuitry acts as an interface between a radio frequency, RF, coupler, shunt resistance sensors and the microcontroller.

4. The circuit breaker of claim 1, wherein the machine learning classifier is a trained neural network.

5. The circuit breaker of claim 1, wherein the microcontroller includes a logic for detecting and tripping the circuit breaker for overcurrent, differential, and arc faults.

6. The circuit breaker of claim 1, wherein the analog signals data is analyzed and classified from specific pre-processing features at each half-cycle by the machine learning classifier.

7. The circuit breaker of claim 1, wherein the computer-readable software code is to:
digitally convert the Received Signal Strength Indicator, RSSI, signal, the voltage signal, and the current signal;
extract half-cycle features from the Received Signal Strength Indicator, RSSI, signal, the voltage signal, and the current signal;
run half-cycle features set through the machine learning classifier; and
analyze an output of the machine learning classifier to determine if half-cycle was an arc or not.

8. The circuit breaker of claim 7, wherein if there is an arc inference, the computer-readable software code is to increment the accumulator value proportional to an amount of the current.

9. The circuit breaker of claim 8, wherein the computer-readable software code is to check whether the accumulator value exceeds a max accumulator threshold and if so trip the circuit breaker.

10. The circuit breaker of claim 7, wherein if there is no arc inference, the computer-readable software code is to decrement the accumulator value proportional to an amount of the current.

11. A method (1300) of arc fault detection by accumulation of machine learning classifications, the method comprising:
providing (1305) a microcontroller including a processor and a memory,
providing (1310) computer-readable software code stored in the memory which, when executed by the processor, causes the microcontroller to:
sample analog signals representing one or more of the following: a Received Signal Strength Indicator, RSSI, signal, a voltage signal, and a current signal;
perform multiple pre-processing steps on the analog signals to derive a data set of measurements and features over a period of time; and
input the data set into a machine learning classifier that resides in the microcontroller such that an output of the machine learning classifier is a value between 0 and 1 which represents a percent chance that the data set is from an electrical arc,
wherein based on the value of the percent chance an accumulator value is either incremented or decremented in proportion to an amount of the current passing through the circuit breaker and if the accumulator value passes an upper threshold level, the microcontroller sends a signal output to a trip circuit which then opens the circuit breaker.

12. The method of claim 11, wherein the period of time is a duration of a half-cycle of the current passing through the circuit breaker and wherein the Received Signal Strength Indicator, RSSI, signal and the current signal come from an analog front-end ASIC circuitry, or wherein the analog front-end ASIC circuitry in particular acts as an interface between a radio frequency, RF, coupler, shunt resistance sensors and the microcontroller.

13. The method of claim 11,
wherein the machine learning classifier is a trained neural network, or
wherein the microcontroller includes a logic for detecting and tripping the circuit breaker for overcurrent, differential, and arc faults, or
wherein the analog signals data is analyzed and classified from specific pre-processing features at each half-cycle by the machine learning classifier.

14. The method of claim 11, wherein the computer-readable software code is to:
digitally convert the Received Signal Strength Indicator, RSSI, signal, the voltage signal, and the current signal;
extract half-cycle features from the Received Signal Strength Indicator, RSSI, signal, the voltage signal, and the current signal;
run half-cycle features set through the machine learning classifier; and
analyze an output of the machine learning classifier to determine if half-cycle was an arc or not.

15. The method of claim 14,
wherein if there is an arc inference, the computer-readable software code is to increment the accumulator value proportional to an amount of the current, wherein in particular the computer-readable software code is to check whether the accumulator value exceeds a max accumulator threshold and if so trip the circuit breaker, or
wherein if there is no arc inference, the computer-readable software code is to decrement the accumulator value proportional to an amount of the current.

## Patentansprüche

1. Leistungsschalter (305; 405), umfassend:
eine Mikrosteuerung (307; 407), die einen Prozessor (310(1)) und einen Speicher (310(2)) beinhaltet,
computerlesbaren Softwarecode (312), der in dem Speicher gespeichert ist, der, wenn er durch den Prozessor ausgeführt wird, die Mikrosteuerung veranlasst:
Analogsignale (705) abzutasten, die Folgendes repräsentieren: ein RSSI-Signal (Received Signal Strength Indicator) und/oder ein Spannungssignal und/oder ein Stromsignal;
mehrere Vorverarbeitungsschritte (715) an den analogen Signalen durchzuführen, um einen Datensatz von Messungen und Merkmalen über eine Zeitperiode abzuleiten; und
den Datensatz in einen Klassifikator (325; 720) für maschinelles Lernen einzugeben, der sich in der Mikrosteuerung befindet, so dass eine Ausgabe des Klassifikators für maschinelles Lernen ein Wert zwischen 0 und 1 ist, der eine prozentuale Wahrscheinlichkeit repräsentiert, dass der Datensatz von einem elektrischen Lichtbogen stammt,
wobei (725) basierend auf dem Wert der prozentualen Wahrscheinlichkeit ein Akkumulatorwert entweder inkrementiert oder dekrementiert wird im Verhältnis zu einer Menge des Stroms, der durch den Leistungsschalter fließt, und wenn der Akkumulatorwert einen oberen Schwellenwert überschreitet, die Mikrosteuerung ein Ausgangssignal an eine Auslöseschaltung (425) sendet, die dann den Leistungsschalter öffnet.

2. Leistungsschalter nach Anspruch 1, wobei die Zeitperiode eine Dauer eines Halbzyklus des Stroms ist, der durch den Leistungsschalter fließt, und wobei das RSSI-Signal (Received Signal Strength Indicator) und das Stromsignal von einer analogen ASIC-Front-End-Schaltung stammen.

3. Leistungsschalter nach Anspruch 2, wobei die analoge Front-End-ASIC-Schaltung als Schnittstelle zwischen einem Hochfrequenz-, HF-, Koppler-, Shunt-Widerstandssensor und der Mikrosteuerung fungiert.

4. Leistungsschalter nach Anspruch 1, wobei der Klassifikator für maschinelles Lernen ein trainiertes neuronales Netzwerk ist.

5. Leistungsschalter nach Anspruch 1, wobei die Mikrosteuerung eine Logik zum Erkennen und Auslösen des Leistungsschalters bei Überstrom-, Differenz- und Lichtbogenfehlern beinhaltet.

6. Leistungsschalter nach Anspruch 1, wobei die analogen Signaldaten bei jedem Halbzyklus durch den Klassifikator für maschinelles Lernen anhand spezifischer Vorverarbeitungsmerkmale analysiert und klassifiziert werden.

7. Leistungsschalter nach Anspruch 1, wobei der computerlesbare Softwarecode dazu dient:
das RSSI-Signal (Received Signal Strength Indicator), das Spannungssignal und das Stromsignal digital umzuwandeln;
aus dem RSSI-Signal (Received Signal Strength Indicator), dem Spannungssignal und dem Stromsignal Halbzyklusmerkmale zu extrahieren;
Halbzyklusmerkmale auszuführen, die durch den Klassifikator für maschinelles Lernen eingestellt werden; und
eine Ausgabe des Klassifikators für maschinelles Lernen zu analysieren, um zu bestimmen, ob der Halbzyklus ein Lichtbogen war oder nicht.

8. Leistungsschalter nach Anspruch 7, wobei der computerlesbare Softwarecode im Falle einer Lichtbogeninferenz den Akkumulatorwert proportional zu einem Strombetrag inkrementieren soll.

9. Leistungsschalter nach Anspruch 8, wobei der computerlesbare Softwarecode prüfen soll, ob der Akkumulatorwert einen maximalen Akkumulatorschwellenwert überschreitet, und wenn dies der Fall ist, den Leistungsschalter auslösen soll.

10. Leistungsschalter nach Anspruch 7, wobei der computerlesbare Softwarecode im Falle keiner Lichtbogeninferenz den Akkumulatorwert proportional zu einem Strombetrag dekrementieren soll.

11. Verfahren (1300) zur Erkennung von Lichtbogenfehlern durch Akkumulation von Klassifizierungen des maschinellen Lernens, wobei das Verfahren umfasst:
Bereitstellen (1305) einer Mikrosteuerung, die einen Prozessor und einen Speicher beinhaltet,
Bereitstellen (1310) eines computerlesbaren Softwarecodes, der in dem Speicher gespeichert ist, der, wenn er durch den Prozessor ausgeführt wird, die Mikrosteuerung veranlasst:
Analogsignale abzutasten, die Folgendes repräsentieren: ein RSSI-Signal (Received Signal Strength Indicator) und/oder ein Spannungssignal und/oder ein Stromsignal;
mehrere Vorverarbeitungsschritte an den analogen Signalen durchzuführen, um einen Datensatz von Messungen und Merkmalen über eine Zeitperiode abzuleiten; und
den Datensatz in einen Klassifikator für maschinelles Lernen einzugeben, der sich in der Mikrosteuerung befindet, so dass eine Ausgabe des Klassifikators für maschinelles Lernen ein Wert zwischen 0 und 1 ist, der eine prozentuale Wahrscheinlichkeit repräsentiert, dass der Datensatz von einem elektrischen Lichtbogen stammt,
wobei basierend auf dem Wert der prozentualen Wahrscheinlichkeit ein Akkumulatorwert entweder inkrementiert oder dekrementiert wird im Verhältnis zu einer Menge des Stroms, der durch den Leistungsschalter fließt, und wenn der Akkumulatorwert einen oberen Schwellenwert überschreitet, die Mikrosteuerung ein Ausgangssignal an eine Auslöseschaltung sendet, die dann den Leistungsschalter öffnet.

12. Verfahren nach Anspruch 11, wobei die Zeitperiode eine Dauer eines Halbzyklus des Stroms ist, der durch den Leistungsschalter fließt, und wobei das RSSI-Signal (Received Signal Strength Indicator) und das Stromsignal von einer analogen Front-End-ASIC-Schaltung stammen, oder wobei die analoge Front-End-ASIC-Schaltung insbesondere als Schnittstelle zwischen einem Hochfrequenz-, HF-, Koppler-, Shunt-Widerstandssensor und der Mikrosteuerung fungiert.

13. Verfahren nach Anspruch 11,
wobei der Klassifikator für maschinelles Lernen ein trainiertes neuronales Netzwerk ist, oder
wobei die Mikrosteuerung eine Logik zum Erkennen und Auslösen des Leistungsschalters bei Überstrom-, Differenz- und Lichtbogenfehlern beinhaltet, oder
wobei die analogen Signaldaten bei jedem Halbzyklus durch den Klassifikator für maschinelles Lernen anhand spezifischer Vorverarbeitungsmerkmale analysiert und klassifiziert werden.

14. Verfahren nach Anspruch 11, wobei der computerlesbare Softwarecode dazu dient:
das RSSI-Signal (Received Signal Strength Indicator), das Spannungssignal und das Stromsignal digital umzuwandeln;
aus dem RSSI-Signal (Received Signal Strength Indicator), dem Spannungssignal und dem Stromsignal Halbzyklusmerkmale zu extrahieren;
Halbzyklusmerkmale auszuführen, die durch den Klassifikator für maschinelles Lernen eingestellt werden; und
eine Ausgabe des Klassifizierers für maschinelles Lernen zu analysieren, um zu bestimmen, ob der Halbzyklus ein Lichtbogen war oder nicht.

15. Verfahren nach Anspruch 14,
wobei, wenn eine Lichtbogeninferenz vorliegt, der computerlesbare Softwarecode den Akkumulatorwert proportional zu einem Betrag des Stroms inkrementieren soll, wobei insbesondere der computerlesbare Softwarecode prüfen soll, ob der Akkumulatorwert einen maximalen Akkumulatorschwellenwert überschreitet, und wenn dies der Fall ist, den Leistungsschalter auszulösen, oder
wobei der computerlesbare Softwarecode im Falle keiner Lichtbogeninferenz den Akkumulatorwert proportional zu einem Strombetrag dekrementieren soll.

## Revendications

1. Disjoncteur (305; 405) comportant :
un microcontrôleur (307; 407) comprenant un processeur (310(1)) et une mémoire (310(2)),
du code logiciel (312) lisible par ordinateur conservé dans la mémoire qui, lorsqu'il est exécuté par le processeur, amène le microcontrôleur à :
échantillonner des signaux analogiques (705) représentant un ou plusieurs des signaux suivants: un signal d'indicateur d'intensité du signal reçu, RSSI, un signal de tension et un signal de courant ;
effectuer de multiples étapes (715) de prétraitement sur les signaux analogiques pour obtenir un jeu de données de mesures et de caractéristiques sur un laps de temps ; et
introduire le jeu de données dans un classificateur (325; 720) d'apprentissage automatique qui réside dans le microcontrôleur de telle façon qu'une sortie du classificateur d'apprentissage automatique soit une valeur entre 0 et 1 qui représente un pourcentage de chances que le jeu de données provienne d'un arc électrique,
d'après la valeur du pourcentage de chances, une valeur d'accumulateur étant soit incrémentée soit décrémentée (725) en proportion d'une quantité du courant traversant le disjoncteur et, si la valeur d'accumulateur franchit un niveau seuil supérieur, le microcontrôleur envoyant une sortie de signal à un circuit (425) de déclenchement qui ouvre alors le disjoncteur.

2. Disjoncteur selon la revendication 1, le laps de temps étant la durée d'une demi-période du courant traversant le disjoncteur et le signal d'indicateur d'intensité du signal reçu, RSSI, et le signal de courant provenant d'une circuiterie ASIC frontale analogique.

3. Disjoncteur selon la revendication 2, la circuiterie ASIC frontale analogique agissant comme une interface entre un coupleur radiofréquence, RF, des capteurs à résistances en dérivation et le microcontrôleur.

4. Disjoncteur selon la revendication 1, le classificateur d'apprentissage automatique étant un réseau neuronal entraîné.

5. Disjoncteur selon la revendication 1, le microcontrôleur comprenant une logique de détection et de déclenchement du disjoncteur pour des défauts de surintensité, différentiels et d'arc.

6. Disjoncteur selon la revendication 1, les données de signaux analogiques étant analysées et classifiées à partir de caractéristiques spécifiques de prétraitement à chaque demi-période par le classificateur d'apprentissage automatique.

7. Disjoncteur selon la revendication 1, le code logiciel lisible par ordinateur étant destiné à :
convertir numériquement le signal d'indicateur d'intensité du signal reçu, RSSI, le signal de tension et le signal de courant ;
extraire des caractéristiques de demi-période à partir du signal d'indicateur d'intensité du signal reçu, RSSI, du signal de tension et du signal de courant ;
faire passer un ensemble de caractéristiques de demi-période à travers le classificateur d'apprentissage automatique ; et
analyser une sortie du classificateur d'apprentissage automatique pour déterminer si la demi-période était un arc ou non.

8. Disjoncteur selon la revendication 7, le code logiciel lisible par ordinateur devant, s'il y a une inférence d'arc, incrémenter la valeur d'accumulateur proportionnellement à une quantité du courant.

9. Disjoncteur selon la revendication 8, le code logiciel lisible par ordinateur devant vérifier si la valeur d'accumulateur dépasse un seuil maxi d'accumulateur et, si oui, déclencher le disjoncteur.

10. Disjoncteur selon la revendication 7, le code logiciel lisible par ordinateur devant, s'il n'y a aucune inférence d'arc, décrémenter la valeur d'accumulateur proportionnellement à une quantité du courant.

11. Procédé (1300) de détection de défauts d'arc par accumulation de classifications d'apprentissage automatique, le procédé comportant les étapes consistant à :
mettre en place (1305) un microcontrôleur comprenant un processeur et une mémoire,
mettre en place (1310) un code logiciel lisible par ordinateur conservé dans la mémoire qui, lorsqu'il est exécuté par le processeur, amène le microcontrôleur à :
échantillonner des signaux analogiques représentant un ou plusieurs des signaux suivants: un signal d'indicateur d'intensité du signal reçu, RSSI, un signal de tension et un signal de courant ;
effectuer de multiples étapes de prétraitement sur les signaux analogiques pour obtenir un jeu de données de mesures et de caractéristiques sur un laps de temps ; et
introduire le jeu de données dans un classificateur d'apprentissage automatique qui réside dans le microcontrôleur de telle façon qu'une sortie du classificateur d'apprentissage automatique soit une valeur entre 0 et 1 qui représente un pourcentage de chances que le jeu de données provienne d'un arc électrique,
d'après la valeur du pourcentage de chances, une valeur d'accumulateur étant soit incrémentée soit décrémentée en proportion d'une quantité du courant traversant le disjoncteur et, si la valeur d'accumulateur franchit un niveau seuil supérieur, le microcontrôleur envoyant une sortie de signal à un circuit de déclenchement qui ouvre alors le disjoncteur.

12. Procédé selon la revendication 11, le laps de temps étant la durée d'une demi-période du courant traversant le disjoncteur et le signal d'indicateur d'intensité du signal reçu, RSSI, et le signal de courant provenant d'une circuiterie ASIC frontale analogique, ou la circuiterie ASIC frontale analogique agissant en particulier comme une interface entre un coupleur radiofréquence, RF, des capteurs à résistances en dérivation et le microcontrôleur.

13. Procédé selon la revendication 11,
le classificateur d'apprentissage automatique étant un réseau neuronal entraîné, ou
le microcontrôleur comprenant une logique de détection et de déclenchement du disjoncteur pour des défauts de surintensité, différentiels et d'arc, ou
les données de signaux analogiques étant analysées et classifiées à partir de caractéristiques spécifiques de prétraitement à chaque demi-période par le classificateur d'apprentissage automatique.

14. Procédé selon la revendication 11, le code logiciel lisible par ordinateur étant destiné à :
convertir numériquement le signal d'indicateur d'intensité du signal reçu, RSSI, le signal de tension et le signal de courant ;
extraire des caractéristiques de demi-période à partir du signal d'indicateur d'intensité du signal reçu, RSSI, du signal de tension et du signal de courant ;
faire passer un ensemble de caractéristiques de demi-période à travers le classificateur d'apprentissage automatique ; et analyser une sortie du classificateur d'apprentissage automatique pour déterminer si la demi-période était un arc ou non.

15. Procédé selon la revendication 14,
le code logiciel lisible par ordinateur devant, s'il y a une inférence d'arc, incrémenter la valeur d'accumulateur proportionnellement à une quantité du courant, le code logiciel lisible par ordinateur devant en particulier vérifier si la valeur d'accumulateur dépasse un seuil maxi d'accumulateur et, si oui, déclencher le disjoncteur, ou
le code logiciel lisible par ordinateur devant, s'il n'y a aucune inférence d'arc, décrémenter la valeur d'accumulateur proportionnellement à une quantité du courant.
